Europäisches Patentamt

European Patent Office

Office européen des brevets

(11) Veröffentlichungsnummer: **0 421 262 A2**

# (12) EUROPÄISCHE PATENTANMELDUNG

(21) Anmeldenummer: **90118520.7**

(22) Anmeldetag: **27.09.90**

(51) Int. Cl.5: **H05K 3/26**, H05K 3/42, B08B 3/02, C23F 1/08

(30) Priorität: **30.09.89 DE 3932779**

(43) Veröffentlichungstag der Anmeldung:
**10.04.91 Patentblatt 91/15**

(84) Benannte Vertragsstaaten:
**AT BE CH DE DK ES FR GB GR IT LI LU NL SE**

(71) Anmelder: **SCHERING AKTIENGESELLSCHAFT**
**Berlin und Bergkamen**
**Müllerstrasse 170/178 Postfach 65 03 11**
**W-1000 Berlin 65(DE)**

(72) Erfinder: **Bläsing, Horst**
**Strünckweg 1**
**W-1000 Berlin 13(DE)**
Erfinder: **Kallweit, Manfred**
**Ragnitzer Allee 3a**
**W-1000 Berlin 19(DE)**
Erfinder: **Schröder, Rolf**
**Sandäckerstrasse 3**
**W-8501 Burgthann(DE)**

(54) **Verfahren zum Behandeln von Gegenständen mit einer Flüssigkeit, sowie Vorrichtung zur Durchführung des Verfahrens.**

(57) Die Erfindung geht aus von einem Verfahren zum Behandeln, einschließlich Spülen, von insbesondere plattenförmig ausgebildeten Gegenständen (1, 1'), z. B. Leiterplatten, mittels einer strömenden und im Schwallstrom an die Gegenstände herangeführte Flüssigkeit, wobei die Gegenstände bevorzugt in Horizontallage transportiert werde, sowie durchgehende Bohrungen (4) und/oder Sackbohrungen (5) aufweisen können. Um den Vorteil eines gleichmäßigen Schwallstromes mit einem wesentlich geringeren Herstellungsaufwand als beim Stand der Technik zu ermöglichen ist hierzu vorgesehen, daß durch Auseinanderspreizen eines Flüssigkeitsstromes, bevorzugt mehrerer nebeneinander im Abstand befindlicher, im Querschnitt etwa kreisrunder Flüssigkeitsteilströme (10), dem Flüssigkeitsstrom eine abgeflachte Form (13) mit einem etwa gleichmäßigen dünnen Querschnitt gegeben wird, daß dieser abgeflachte Flüssigkeitsstrom (13) etwa quer zur Transportrichtung (2) der zu behandelnden Gegenstände (1, 1') verläuft und an den Gegenstand mit einem Anströmwinkel ($\alpha$) herangeführt wird. Ferner betrifft die Erfindung eine Vorrichtung zur Durchführung des Verfahren mit einer plattenförmigen Leiteinrichtung (12), die zur Austrittsrichtung (10) der Behandlungsflüssigkeit in einem spitzen Auftreffwinkel ($\beta$) steht und mit zu behandelnden Gegenstand den Anströmwinkel ($\alpha$) bildet.

Fig. 1

## VERFAHREN ZUM BEHANDELN VON GEGENSTÄNDEN MIT EINER FLÜSSIGKEIT, SOWIE VORRICHTUNG ZUR DURCHFÜHRUNG DES VERFAHRENS

Die Erfindung betrifft zunächst ein Verfahren gemäß dem Oberbegriff des Ansprüches 1. Die zu behandelnden Gegenstände können unterschiedliche Formgebung aufweisen. Bevorzugt sind sie plattenförmig. Sie können an ihrer Oberfläche glatt oder strukturiert sein. Bei plattenförmiger Ausbildung können sie mit durchgehenden Bohrungen und/oder ein- oder beidseitig mit Sackbohrungen versehen sein. Insbesondere ist dabei an mit Bohrungen und/oder Sackbohrungen versehenen, zum Einsatz in der Elektronik bestimmte Leiterplatten gedacht. Die Flüssigkeitsbehandlung kann entweder zur Reinigung, bzw. Abspülen der Gegenstände dienen, wobei als Behandlungsflüssigkeit bevorzugt Wasser vorgesehen wird. Die Behandlung kann aber auch chemischer Art sein, wobei eine der jeweiligen chemischen Behandlung dienende Behandlungsflüssigkeit eingesetzt wird. Die Verwendung von sogenannten Schwall-Strecken hat dabei den Vorzug, daß die Behandlungsflüssigkeit im Schwall besonders intensiv an den Gegen stand gelangt und vor allem in Bohrungen oder Sackbohrungen der Gegenstände hindurchgebracht (durchflutet) bzw. hineingedrückt wird. Die Behandlung in den einzelnen Prozeßstufen, wie Spülen, Reinigen oder chemisches Behandeln ist durch den auf den Gegenstand treffenden Schwallstrom sehr intensiv und gründlich. Einrichtungen der vorgenannten Art sind bekannt (siehe DE-PS 30 11 061 und DE-OS 35 28 575) , wobei die Resultate der Behandlung von Gegenständen, insbesondere Leiterplatten (auch solche ohne Bohrungen) nach den vorbekannten Verfahren und mit den dazugehörigen Vorrichtungen befriedigend sind. Es wird dabei im wesentlichen ein gleichmäßiges Strömungsverhalten der Schwall-Strecke erreicht, die insbesondere in Bohrlöchern ein befriedigendes Hindurchströmen der Flüssigkeit gewährleistet. Nachteilig ist jedoch, daß die bekannten Verfahren konstruktiv aufwendige Vorrichtungen bedingen, die außerdem einen relativ großen Raumbedarf haben. Hiermit ergeben sich die Nachteile eines hohen Fertigungsaufwandes mit entsprechend teuren Fertigungskosten und großen Bauteilabmessungen, die dem Bau kompakter Anlagen entgegenstehen.

Die Aufgabe der Erfindung besteht demgegenüber zunächst darin, ein Verfahren gemäß dem Oberbegriff des Ansprüches 1 dahingehend zu gestalten, daß der Vorteil eines gleichmäßigen Schwallstromes mit einem wesentlich geringeren Herstellungsaufwand als beim Stand der Technik möglich ist.

Die Lösung dieser Aufgabe wird ausgehend vom Oberbegriff des Ansprüches 1 in den Merkmalen des Kennzeichens des Ansprüches 1 gesehen. Mehrere im Abstand befindliche, im Querschnitt etwa kreisrunde Flüssigkeitsteilströme sind in einfachster Weise zu realisieren, z.B. durch ein Rohr mit entsprechenden Bohrungen. Das Auseinanderspreizen dieser Flüssigkeitsteilströme und damit die Bildung des abgeflachten Flüssigkeitsstromes ist ebenfalls mit sehr einfachen Bauteilen zu realisieren.

Ferner ermöglicht das Verfahren gemäß Anspruch 1 mit ebenso einfachen Mitteln eine stufenweise oder bevorzugt stufenlose Änderung des Anströmwinkels gemäß Anspruch 2, d.h. der für die Behandlung mit der Flüssigkeit wesentliche Anströmwinkel kann den jeweiligen Anforderungen angepaßt werden, die sich aus der Gestaltung der zu behandelnden Gegenstände ergeben, insbesondere aus Lage und Größe zu behandelnder Bohrungen.

Mit der Lehre des Ansprüches 3 kann man sich weiterhin den jeweils gegebenen Anforderungen anpassen.

Weiter besteht die Aufgabe der Erfindung darin, eine zur Durchführung des Verfahrens dienende Vorrichtung zu schaffen. Hierzu wird, ausgehend vom Oberbegriff des Ansprüches 4, zunächst die Merkmalsanordnung gemäß dem Kennzeichen des Ansprüches 4 vorgesehen. Der notwendige bauliche Aufwand besteht im Prinzip nur aus den Austrittsöffnungen und der Leiteinrichtung. Er ist also wesentlich geringer und auch kompakter als bei den vorbekannten Einrichtungen.

Eine bevorzugte Ausführungsform der Erfindung ist Gegenstand des Ansprüches 8. Durch diese Krümmung wird das Auseinanderspreizen der einzelnen Flüssigkeitsteilströme, die durch die Zentripetalkräfte verursacht werden, noch verstärkt.

Eine weitere bevorzugte Ausführung der Erfindung ist Gegenstand des Ansprüches 10. Hiermit wird sowohl der Anströmwinkel zwischen dem abgeflachten Flüssigkeitsstrom und dem zu behandelnden Gegenstand, als auch der Auftreffwinkel der Flüssigkeitsteilströme auf die Leiteinrichtung verändert, d.h. er kann den jeweiligen Erfordernissen der Praxis angepaßt werden.

Weitere Merkmale und Vorteile der Erfindung sind den weiteren Unteransprüchen, sowie der nachstehenden Beschreibung und der zugehörigen Zeichnung von erfindungsgemäßen Ausführungsbeispielen zu entnehmen. In der Zeichnung zeigt:

Fig. 1: schematisch die Seitenansicht eines Ausführungsbeispieles nach der Erfindung,

Fig. 2: einen Schnitt gemäß der Linie II-II in Fig. 1,

Fig. 3: die qualitative Darstellung der Flüssigkeitsströmung und der Geschwindigkeitsverteilung nach der Erfindung,

Fig. 4: eine qualitative Darstellung der Flüssigkeitsströmung und der Geschwindigkeitsverteilung ohne die Leiteinrichtung.

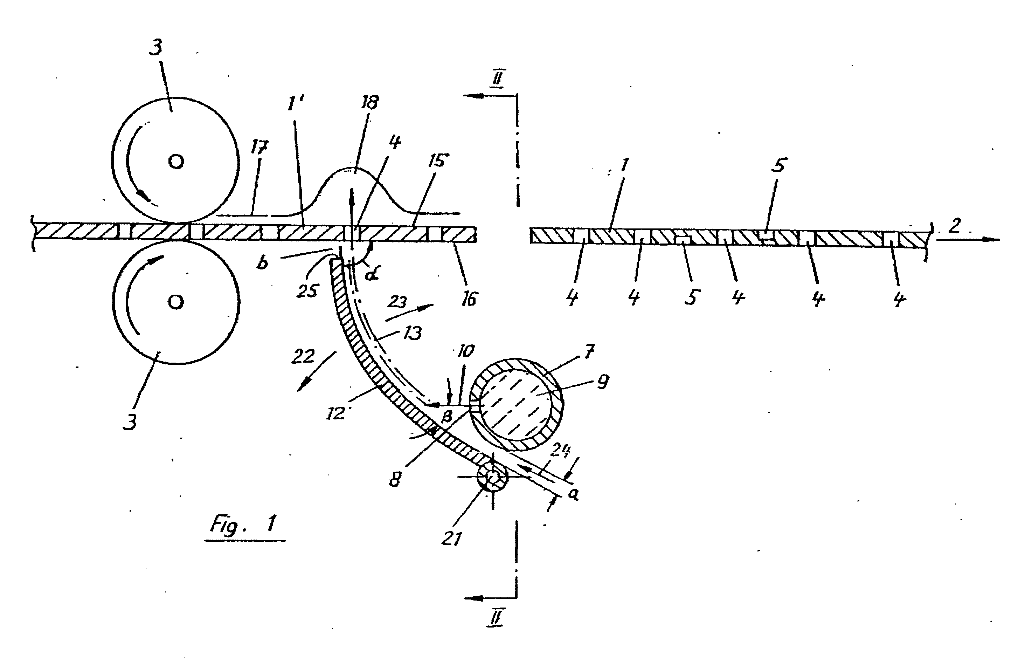

Die Seitenansicht der Fig. 1 zeigt zwei zu behandelnde Gegenstände 1, 1', die in Horizontallage in Pfeilrichtung 2 mit Hilfe von Transporteinrichtungen, z.B. Transportwalzen 3, transportiert werden. Im vorliegenden Ausführungsbeispiel bestehen die Gegenstände 1, 1' aus Leiterplatten, die mit durchgehenden Bohrungen 4 versehen sind. Sie könnten auch Sackbohrungen 5 aufweisen, die an der in Transportrichtung oberen Fläche 15 und/oder unteren Fläche 16 vorgesehen sind. Falls nur durchgehende Bohrungen 4 oder nur nach unten offene Sackbohrungen 5 im zu behandelnden Gegenstand vorgesehen sind, genügt die in diesem Ausführungsbeispiel dargestellte Erzeugung eines Schwallstromes von unten her. Falls an der oberen Fläche 15 des in solchen horizontalen Anlagen durchlaufenden Gegenstandes Sackbohrungen 5 vorgesehen sind, müssen diese mit einem von oben herangeführten Schwallstrom behandelt werden. Ein solcher von oben kommender Schwallstrom (in der Zeichnung nicht dargestellt) kann ferner auch zur Behandlung von durchgehenden Bohrungen 4 eingesetzt werden.

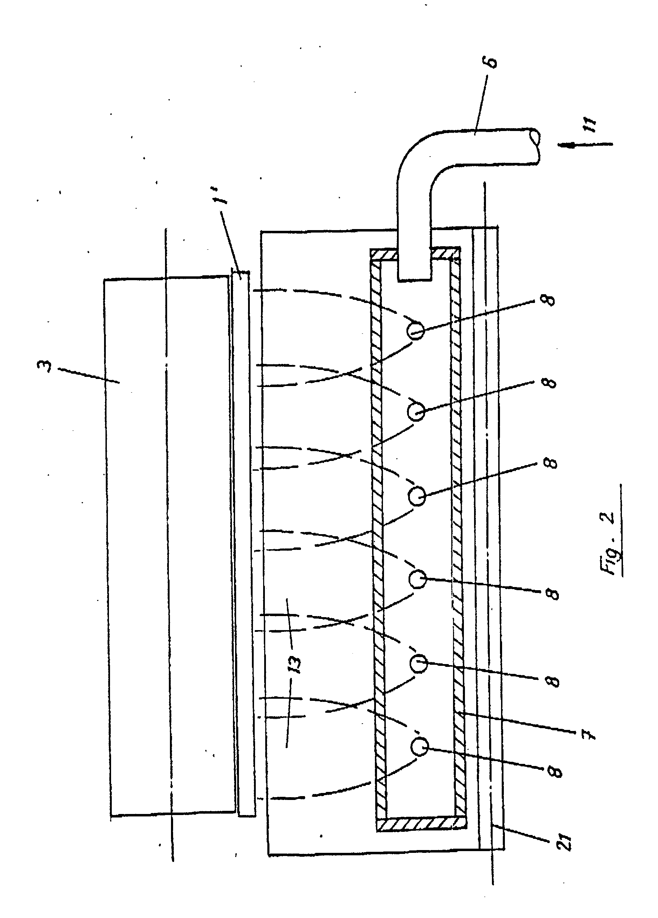

Die Behandlungsflüssigkeit (fluid) wird über eine Zuleitung 6 einer Verteilereinrichtung in Form eines Rohres 7 zugeführt, das mit einer Reihe nebeneinander angeordneter Austrittsöffnungen 8 versehen ist (siehe auch Fig. 2). Im übrigen ist das Rohr abgeschlossen. Der grob schraffierte Querschnitt 9 des Rohres 7 (siehe Fig. 1) ist größer als der Querschnitt aller Austrittsöffnungen 8. Somit wird die Geschwindigkeit der gemäß Pfeil 10 aus den Austrittsöffnungen 8 ausströmenden Flüssigkeitsteilströme größer sein als die Geschwindigkeit der bei 11 zufließenden Flüssigkeit. Die Austrittsöffnungen 8 können als Düsen ausgebildet sein.

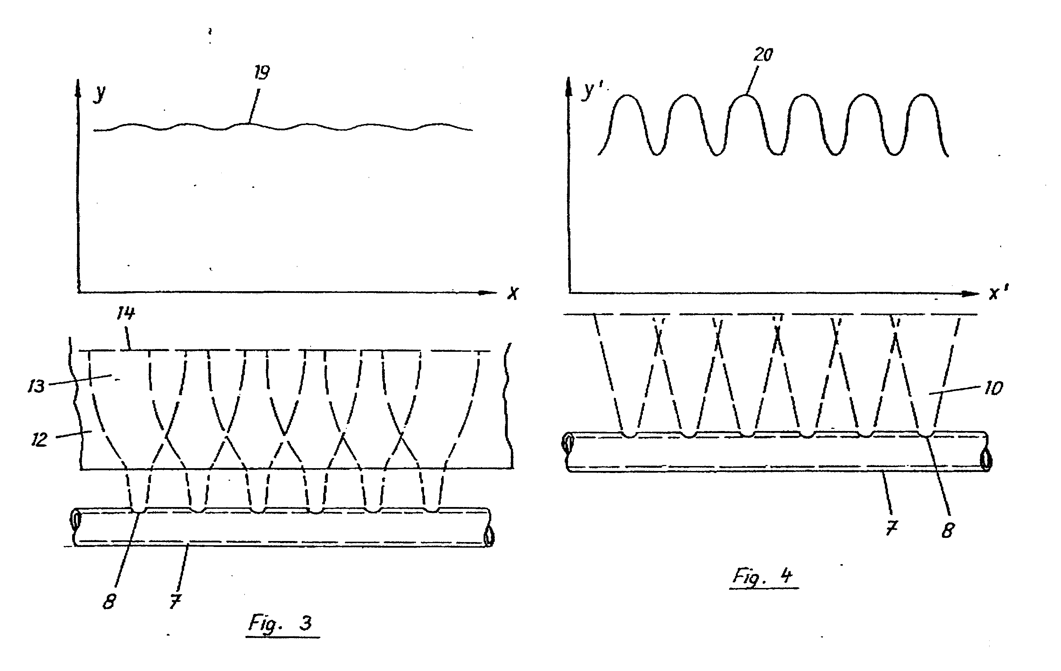

Die Strömungsrichtung 10 der aus den Öffnungen 8 austretenden Flüssigkeitsteilströme bildet mit einer noch näher zu erläuternden Leiteinrichtung 12 einen Auftreffwinkel $\beta$. Dieser Winkel $\beta$ ist spitz, so daß die Flüssigkeit nach ihrem Auftreffen auf die Leiteinrichtung gemäß der strichpunktiert eingezeichneten Linie 13 nach oben hin abgelenkt wird, bis sie mit dem Anströmwinkel $\alpha$ auf den zu behandelnden Gegenstand 1, bzw. 1', im vorliegenden Ausführungsbeispiel eine mit den Bohrungen 4 und gegebenenfalls 5 versehene Leiterplatte auftrifft. Fig. 2 und 3 zeigen, wie die Teilströme 10 sich aufgrund ihres Auftreffens auf die zumindest an der Auftreffseite plattenförmige Leiteinrichtung 12 fächerförmig auseinanderbreiten und somit eine abgeflachte Form 13 mit einem relativ dünnen Querschnitt bekommen, welche unterhalb des zu behandelnden Gegenstandes einen entsprechenden Schwallstrom 14 bildet, der gegen die Unterseite des Gegenstandes 1' anströmt und durch deren Bohrungen 4 hindurchströmt. Die hindurchgeströmte Flüssigkeit steht auf der oberen Fläche 15 in einem relativ dünnen Flüssigkeitsbett 17, das aber aufgrund der Durchtrittsgeschwindigkeit des Schwalles 14 oberhalb der Bohrungen 4 eine Art "Buckel" 18 bildet.

In den Fig. 3 und 4 ist jeweils in der oberen Hälfte ein Diagramm aufgetragen, das in der Ordinate die Geschwindigkeit y des an den zu behandelnden Gegenstand anströmenden Flüssigkeitsstromes und in der Abszisse die Breite x des zu behandelnden Gegenstandes (gleich der Länge des Rohres 7) darstellt. Fig. 3 zeigt die erläuterte Anordnung nach der Erfindung mit dem Ergebnis, daß die Anströmgeschwindigkeit des abgeflachten Flüssigkeitsstromes auf den Gegenstand 1, bzw. 1' über die gesamte Gegenstandsbreite nahezu konstant ist. Dagegen zeigt Fig. 4 eine Anordnung mit Rohr 7 und Austrittsöffnungen 8, jedoch ohne die Leiteinrichtung 12. Die Teilströme 10 werden nicht aufgefächert und damit nicht abgeflacht. Hiermit ergibt sich eine über die Länge x' des Rohres 7 relativ stark schwankende, etwa sinus-förmige Anströmgeschwindigkeit y' der Behandlungsflüssigkeit.

Die Leiteinrichtung verläuft, wie bereits erwähnt, quer zur Transportrichtung 2 der Gegenstände 1, 1' (siehe auch Fig. 2). Sie ist in dieser Querrichtung um eine Achse, hier eine Anlenkung 21, in Richtung der Pfeile 22, 23 verschwenkbar. Damit sind sowohl der Anströmwinkel $\alpha$ als auch der Auftreffwinkel $\beta$ variierbar. Dies ist besonders hinsichtlich des Anströmwinkels $\alpha$ von Bedeutung, der somit der Gestaltung von Ausnehmungen und Öffnungen an der betreffenden Seite des zu behandelnden Gegenstandes angepaßt werden kann. Die Anlenkung 21 kann in einem gewissen Abstand a vom Rohr 7 vorgesehen sein, so daß die Flüssigkeitsteilströme 10 mit Injektorwirkung durch den Spalt a Behandlungsflüssigkeit 24 hindurchziehen können, sofern sich dieser Bereich und auch die Austrittsöffnungen 8 innerhalb eines Bades aus Behandlungsflüssigkeit befinden. Es wäre statt dessen aber auch in konstruktiv vereinfachter Form möglich, die Anlenkung 21 unmittelbar am Rohr 7 in dessen unteren Bereich vorzusehen (zeichnerisch nicht dargestellt). In diesem Fall würde keine Injektorwirkung eintreten und es wäre auch nicht die Anordnung dieses Bereiches in einem Bad notwendig. Zwischen der in Fig. 1 oberen Stirnkante 25 der Leiteinrichtung und der unteren Fläche 16 des Gegenstandes 1, bzw. 1' ist ein relativ kleiner Zwischenraum b vorgesehen. Dies ist zum einen im Hinblick auf Toleranzen in der Dicke der zu behandelnden Gegenstände und ferner dann notwendig, wenn gemäß der bevorzugten Ausführungsform der Erfindung die Leiteinrichtung 12 gemäß Pfeilen 22, 23 verschwenkbar ist, da sich hiermit die Entfernung zwischen der Stirnkante 25 und der unteren Fläche 16 ändert.

Fig. 1 zeigt, daß die Leiteinrichtung 12 bogenförmig gekrümmt sein kann und zwar in einer Richtung, daß die Strömungsrichtung der abgeflachten Flüssigkeit 13 immer mehr von ihrer Austrittsrichtung 10 abgelenkt wird. Hiermit wird die erläuterte auf die Flüssigkeit einwirkende Zentripetalkraft entsprechend größer, was eine Verstärkung der Spreizwirkung und damit ein weiteres Vergleichmäßigen der Anströmgeschwindigkeit y auf den zu behandelnden Gegenstand zur Folge hat. Diese Krümmung kann in Kreisbogenform ausgebildet sein.

Es erfolgt also zunächst eine Erhöhung der Strömungsgeschwindigkeit der Flüssigkeit beim Austritt aus den Öffnungen 8 und dann eine weitere Erhöhung durch ihre Auseinanderspreizung und die Zentripetalkraft. Der auf dem Gegenstand auftreffende, auseinandergespreizte Flüssigkeitsstrom ist aber nicht eine versprühte Flüssigkeit, sondern der bereits erwähnte Schwallstrom. In diesem Schwallstrom wird die kinetische Energie des Fluids in Druckenergie umgesetzt und die gewünschte Durchströmung der Bohrungen, bzw. Spülung von Ausnehmungen von Sackbohrungen erreicht.

**Ansprüche**

1. Verfahren zum Behandeln, einschließlich Spülen, von insbesondere plattenförmig ausgebildeten Gegenständen, z.B. Leiterplatten, mittels einer strömenden und im Schwallstrom an die Gegenstände herangeführte Flüssigkeit, wobei die Gegenstände bevorzugt in Horizontallage transportiert werden, sowie durchgehende Bohrungen und/oder Sackbohrungen aufweisen können, dadurch gekennzeichnet , daß durch Auseinanderspreizen eines Flüssigkeitsstromes, bevorzugt mehrerer nebeneinander im Abstand befindlicher, im Querschnitt etwa kreisrunder Flüssigkeitsteilströme (10), dem Flüssigkeitsstrom eine abgeflachte Form (13) mit einem etwa gleichmäßigen dünnen Querschnitt gegeben wird, daß dieser abgeflachte Flüssigkeitsstrom (13) etwa quer zur Transportrichtung (2) der zu behandelnden Gegenstände (1, 1´) verläuft und an den Gegenstand mit einem Anströmwinkel ($\alpha$) herangeführt wird.

2. Verfahren nach Anspruch 1, dadurch gekennzeichnet, daß eine stufenweise oder stufenlose Änderung des Anströmwinkels ($\alpha$) zwischen dem zu behandelnden Gegenstand (1, 1´) und dem darauf treffenden abgeflachten Flüssigkeitsstrom (13) vorgesehen ist.

3. Verfahren nach Anspruch 1 oder 2, gekennzeichnet durch eine Behandlung der Gegenstände (1, 1´) von oben und/oder von unten mittels eines oder zweier abgeflachter Flüssigkeitsströme (13).

4. Vorrichtung zur Durchführung des Verfahrens nach einem der Ansprüche 1 bis 3 mit einer die zu behandelnden Gegenstände bevorzugt in Horizontallage transportierenden Anordnung und einer unter Druck stehenden Zufuhr der Behandlungsflüssigkeit, dadurch gekennzeichnet , daß dem Austrittsquerschnitt (8) der Zufuhr (11, 7) der Behandlungsflüssigkeit eine zumindest auftreffseitig plattenförmige Leiteinrichtung (12) nachgeordnet ist, die sich über die gesamte Breite (x) der zu behandelnden Gegenstände erstreckt und zu der Austrittsrichtung (10) der Behandlungsflüssigkeit aus dem Austrittsquerschnitt (8) in einem spitzen Auftreffwinkel ($\beta$) steht und bis dicht an den zu behandelnden Gegenstand (1, 1´) führt, sowie mit diesem einen Anströmwinkel ($\alpha$( bildet.

5. Vorrichtung nach Anspruch 4, dadurch gekennzeichnet, daß als Austrittsquerschnitt eine Reihe nebeneinander angeordnete Bohrungen (8), z.B. in Düsenform, vorgesehen ist.

6. Vorrichtung nach Anspruch 4 oder 5, dadurch gekennzeichnet, daß in der Wandung eines Zufuhrrohres (7) der Behandlungsflüssigkeit Austrittsöffnungen (8) in Form von Bohrungen nebeneinander angeordnet sind, die in der Austrittsrichtung (10) zur Leiteinrichtung (12) hin gerichtet sind.

7. Vorrichtung nach Anspruch 6, dadurch gekennzeichnet, daß der Querschnitt (9) des Zufuhrrohres größer ist als die Summe der Querschnitte der Austrittsöffnungen (8).

8. Vorrichtung nach einem der Ansprüche 4 bis 7, dadurch gekennzeichnet, daß die Leiteinrichtung (12) leicht gekrümmt ausgebildet ist, wobei die Krümmung zur Strömungsrichtung der Behandlungsflüssigkeit so verläuft, daß sie den in Auseinanderspreizung befindlichen Flüssigkeitsstrom immer mehr von seiner ursprünglichen Austrittsrichtung (10) ablenkt.

9. Vorrichtung nach Anspruch 8, gekennzeichnet durch eine Krümmung in Kreisbogenform.

10. Vorrichtung nach einem der Ansprüche 4 bis 9, dadurch gekennzeichnet, daß die Leiteinrichtung (12) um eine Achse (21) schwenkbar ist, die sich bevorzugt in der Nähe der Flüssigkeitszufuhr (7, 8) befindet.

11. Vorrichtung nach einem der Ansprüche 4 bis 10, dadurch gekennzeichnet, daß die Leiteinrichtung (12) mit ihrem unteren Bereich unmittelbar an das Zufuhrrohr (7) anschließt.

12. Vorrichtung nach einem der Ansprüche 4 bis 10, dadurch gekennzeichnet, daß zwischen dem unteren Bereich der Leiteinrichtung (12) und dem Zufuhrrohr (7) ein Spalt (a) vorgesehen ist, wobei sich dieser Bereich und der Spalt (a) in einem Bad

der Behandlungsflüssigkeit befinden.

Fig. 1

EP 0 421 262 A2

Fig. 2

Fig. 4

Fig. 3